Europäisches Patentamt

European Patent Office

Office européen des brevets

(11) Publication number: **0 452 031 A2**

# EUROPEAN PATENT APPLICATION

(21) Application number: **91302926.0**

(51) Int. Cl.[5]: **H03L 7/197**

(22) Date of filing: **03.04.91**

(30) Priority: **07.04.90 GB 9007949**

(43) Date of publication of application:
**16.10.91 Bulletin 91/42**

(84) Designated Contracting States:
**DE FR IT**

(71) Applicant: **FERRANTI INTERNATIONAL plc**
**Bridge House Park Road Gatley**
**Cheadle Cheshire SK8 4HZ (GB)**

(72) Inventor: **Wilson, Martin Paul**
**42 Sandholme Close, Giggleswick**
**N. Yorkshire, BD24 0AF (GB)**

(74) Representative: **Bradley, David Nicholas et al**
**Patents Department Ferranti International plc**
**Bridge House Park Road Gatley**
**Cheadle, Cheshire SK8 4HZ (GB)**

(54) Signal generation using digital-to-analogue conversion.

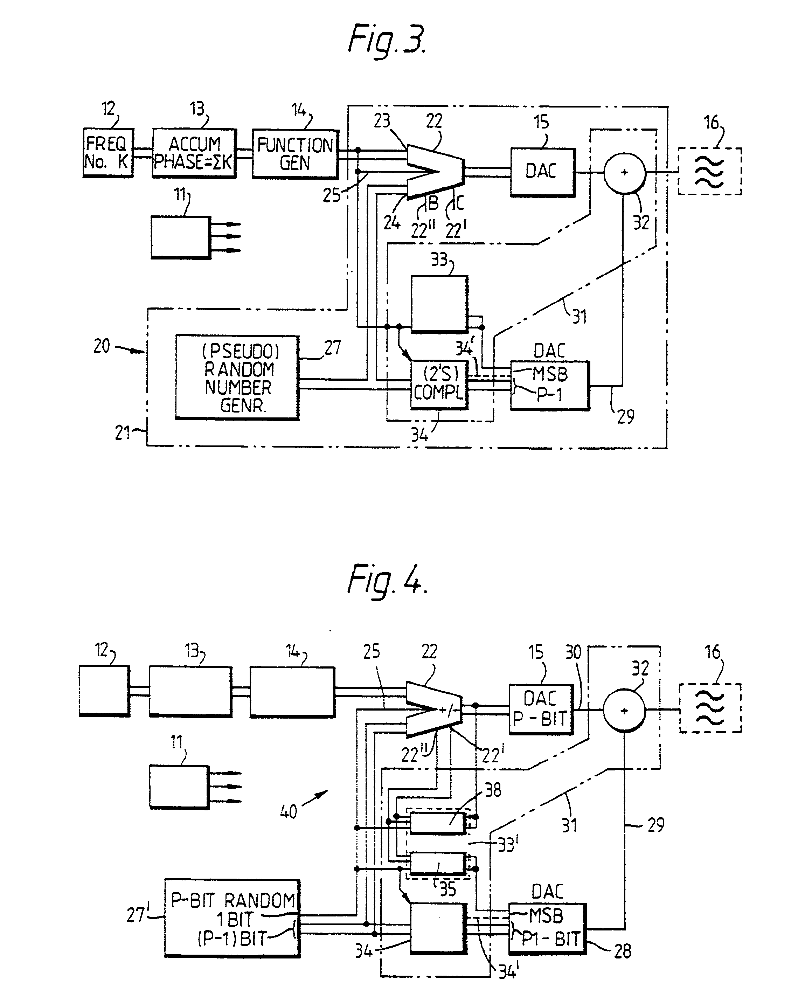

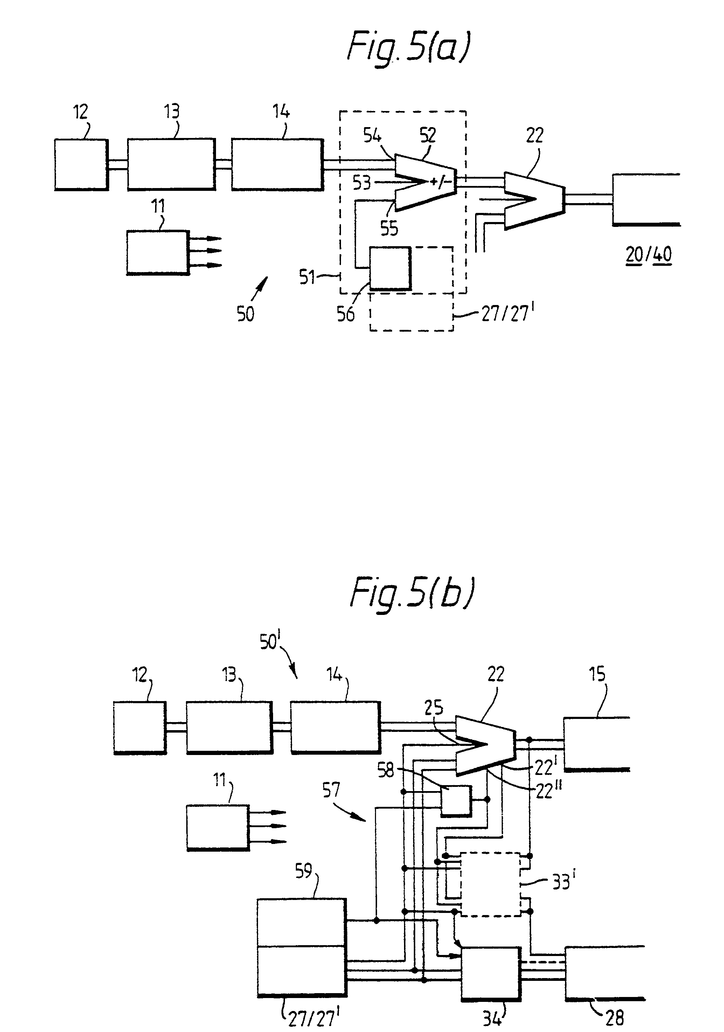

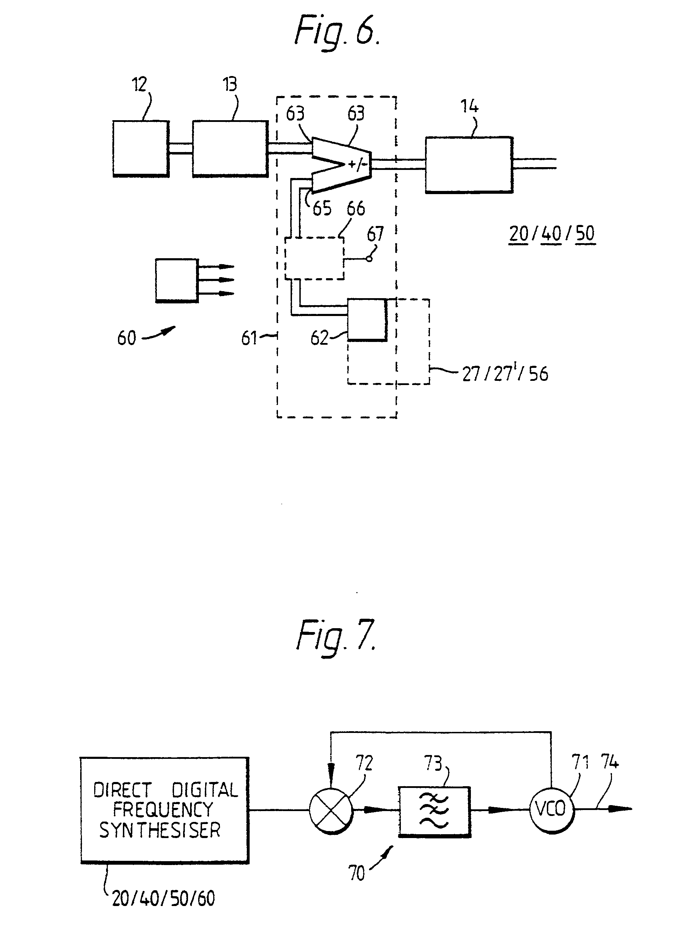

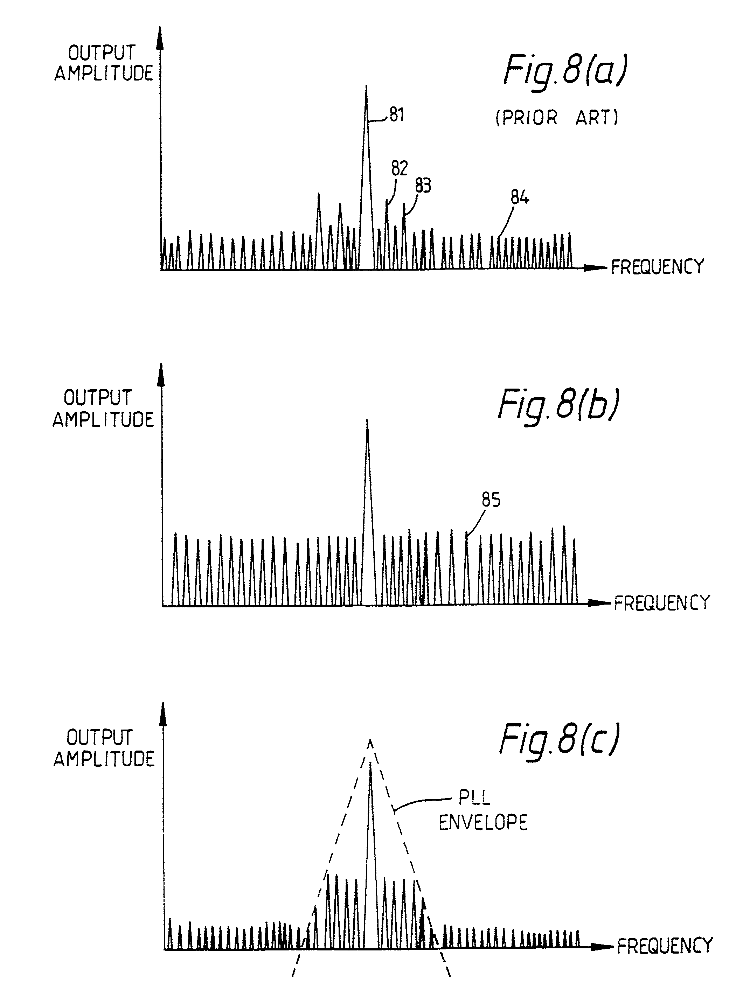

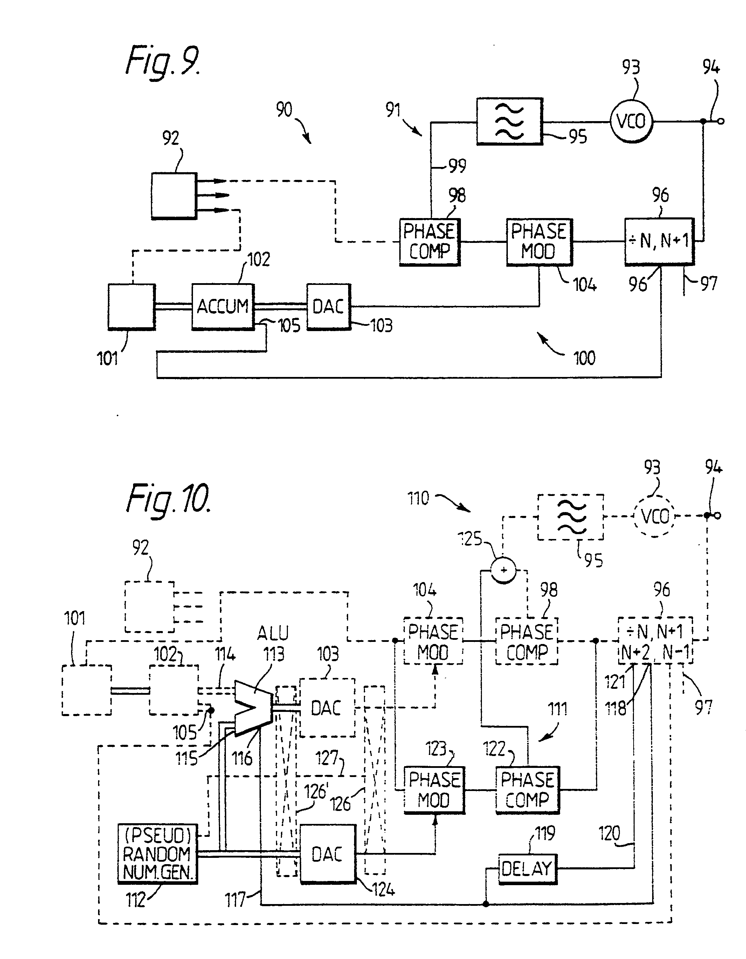

(57) A circuit for generating an analogue signal by way of digital-to-analogue conversion, such as a direct digital frequency synthesiser (Fig. 3) of the type including a frequency number generator 12, phase number accumulator 13, function number generator 14, such as a look-up table of sine values, and DAC 15 mitigates the production of analogue signal errors, manifested as spurious frequency signals, by modifying the digital number representing each function value with a random digital number added or subtracted in ALU 22. The randomly modified function number and random digital number are converted to analogue values in DAC 15 and further DAC 28 respectively and the analogue values combined to remove the effect of the random number. Because conversion in DAC 15 is spread randomly over all DAC levels, even when the function number is not, any conversion errors associated with any DAC steps which by repeated use would be manifested as spurious frequency signals are decorrelated to broadband noise. Less troublesome correlations due to function number truncation may be mitigated by limited random dithering of the phase number (Fig. 6) and randomly dithering rounding of the function number (Fig. 5).A similar circuit (100, Fig.10) generating a sawtooth signal may be employed in improving phase control linearity in a phase locked loop frequency synthesiser.

EP 0 452 031 A2

Fig.3.

This invention relates to the generation of continuous analogue signals from repeated application of digital numbers to digital-to-analogue conversion means and in particular to mitigation of the effects of distortion in such analogue signals caused by the digital-to-analogue conversion means.

The invention is particularly, but not exclusively, concerned with the generation of analogue signals at specific frequencies, so-called frequency synthesis, and mitigating the production of spurious frequencies inherent in such analogue signal distortion.

The invention may be applied to so-called direct digital synthesis, in which the digital-to-analogue conversion means delivers an analogue signal of appropriate frequency, and to phase locked loop synthesis, in which in a phase locked loop, incorporating a voltage controlled oscillator, a circuit controlling loop phase error incorporates digital-to-analogue conversion means in a manner similar to direct digital synthesis.

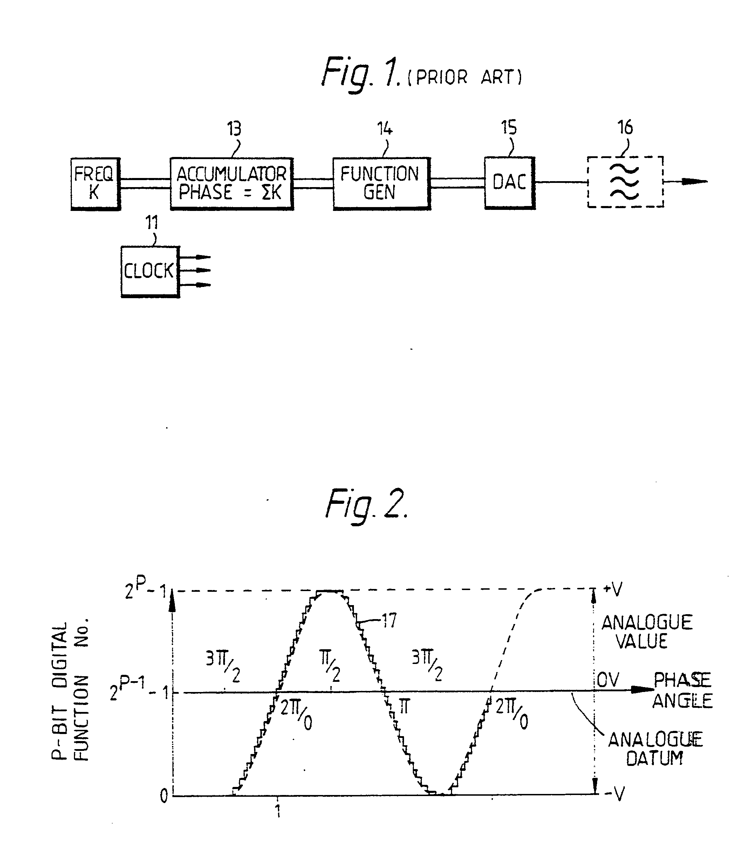

The basic form of direct digital synthesiser with which the invention is concerned is illustrated at 10 in Figure 1 and comprises a system clock 11, a digital number generator 12 which provides a number, conventionally identified as K, representing the frequency to be synthesised, an accumulator 13 to which the number is added at each system clock cycle to provide a series of "phase" numbers increasing linearly with time and a digital function generator 14, such as a read only memory (ROM), which defines the form of the signal to be generated, for example sinusoidal, as a further series of numbers. All the numbers are formed as digital binary words and a digital-to-analogue converter (DAC) 15 generates a series of analogue values corresponding to the numbers represented by the words which in time define the signal having a waveform defined by function generator 14 and at a frequency defined by the value of number K. The output of the DAC 15 may be passed by way of an anti-aliasing filter 16.

It is convenient to, and at times this specification will refer to, numbers synonymously with the digital binary words representing those numbers unless the context of the description makes it more appropriate to consider the structure of the words themselves.

Such basic form of direct digital frequency synthesiser and modifications thereto are described in UK Specification no. 2121627B.

It is also a feature of such basic form of direct digital frequency synthesiser, and also described in the above referenced UK patent specification, that the analogue signal generated is not confined to the desired frequency represented by number K but it also accompanied by unwanted spectral components or spurii attributable to DAC operation.

Furtheremore if truncation of the digitial word length is required for any component, such truncation also adds spurious spectral components, although dominated by those related to the DAC.

Spurious generation in the DAC may be due inter alia to differential non-linearity, switching transient errors and quantisation errors. Switching transient errors manifested as energy present at the DAC output are particularly troublesome with synthesisers having a high clock speed able to operate at high clock speeds used to generate high frequency signals.

It has been proposed to use a high speed sample-and-hold device to the output of the DAC to remove switching transients by sampling only after the DAC has settled for each input word. However, in generating high frequencies, the duration of each output level may be shorter than the settling time of the DAC so that even high speed sample-and-hold devices, which may themselves introduce an unacceptable cost penalty, may be unable to satisfactorily remove switching transients.

It has also been suggested in US patent specification no. 4410954 to avoid the problems caused by DAC use by omitting the function generator and DAC. However, the elimination of the DAC results in low overall signal-to-noise ratio and phase noise sidebands unacceptable for most communications systems or where frequency hopping is required.

In order to address the error mechanisms due to DAC operation the above mentioned UK patent no. 2121627B identifies that the high levels of spurii arise from correlation of errors due to repetition of an error at a particular DAC step each time a particular word is output from the function generator. That specification proposes to relieve the effect by 'randomising' the digital-to-analogue conversion by control of the DAC whereby for any particular phase numbers produced by the accumulator the DAC response to the function generated is pseudo-randomly varied to try to spread the hitherto correlated narrow-band spurii at frequencies close to the sought frequency across the frequency band as wide-band noise.

Several arrangements are proposed therein but all are restricted to being a random choice between two sets of devices having slightly different chacateristics and are believed to provide insufficient relief for use in generating very high signal frequencies that in practice require system clock frequencies in the GHz range and high rates of frequency changing.

One form of the 'randomising' proposed comprises the use of two DACs with switching means randomly placing one DAC or the other in circuit. If each is responding to the same digital function generator word the DACs must operate with ostensibly the same characteristics and randomisation is due only to the actual differences which exist between nominally identical devices. If each DAC is paired with an individual function generator then the DAC and/or its operating reference can be adjusted to provide considerably different error response than the other. However, there is a limit to how different from each other the DACs can be whilst accurately converting the principal signal and with any selected pair of devices the randomness is confined to a band representing the difference in their characteristics. Furthermore, there is the need to provide switching which may prove difficult to engineer for generating very high frequencies without also introducing undesirable transient energy effects.

As an alternative to switching between different DAC devices that patent proposes to use a scaling DAC with randomly varied scale control and DAC reference. Although the switching is absent a multiplying DAC is required which cannot operate as fast as a fixed reference DAC and is unsuitable for generating very high frequencies.

Single phase-locked loop frequency synthesisers are also well known per se, the loop oscillator frequency being controlled by phase comparison of a reference frequency and one provided by division of the oscillator output frequency by a number N, the resultant phase difference drifting until at a phase angle $2\pi$ with respect to the reference frequency it self-corrects with a repetitive phase jitter characteristic of such circuits. Any VCO phase jitter due to other sources can be corrected provided they are within the loop bandwidth. The frequency division is performed in a digital counter circuit and by definition the number N is an integral and the smallest frequency interval that can be generated, or frequency resolution, is limited by the integral number step and the reference frequency. Achieving a high frequency resolution by means of a low reference frequency is not always practicable as it requires a small loop bandwidth and results in slow loop response, conflicting with requirements of high loop speed and wide bandwidth for noise reflection.

It has become common practice to avoid the conflict by effectively introducing fractions of the integer N, by so-called fractional-N synthesis. In this technique the divider is switched at intervals from divide-by-N to divide-by-(N+1) for a cycle of the reference frequency signal, the interval being determined in accordance with what is in effect the integral of a fractional frequency instruction, also usually defined by a digital number. The integration takes place in a digital accumulator, overflow of which effects the aforementioned one cycle change of divisor from N to (N+1), but although simple in concept, it suffers a drawback in that alteration of the divisor results in additional phase perturbations or jitter. Because such additional perturbations are directly related to the residul content of the overflowed accumulator, the effect can be mitigated by deriving an analogue representation of this residual content in a digital-to-analogue converter (DAC) and either inflecting it into the loop at the output of the phase comparator or applying it to a phase modulator which restores the phase of the divided VCO signal applied to the phase comparator. Such a configuration is illustrated schematically in Figure 9 and described in more detail hereinafter.

It has been suggested that mitigating this additional jitter by such analogue signal is only practicable when the phase detector is operated at frequencies significantly below its potential maximum. This is due, at least in part, to non-linearity of the DAC and repeated use of DAC steps.

It will be appreciated that the source of the number representing the fractional frequency instruction, or alternatively stated, the desired oscillator output frequency, the accumulator and DAC comprise the elements of a direct digital synthesiser substantially as described above but which, by virtue of its direct connection between linearly increasing accumulator output and DAC, generates over a period of time an analogue signal having a sawtooth waveform.

Notwithstanding the specific nature of the circuits described above for generating signals of specific frequency, it is an object of the present invention to provide a method of mitigating effects of distortion on an analogue signal derived from repeated application of digital numbers to digital-to-analogue conversion means and a circuit arrangement for generating an analogue signal in which such effects are mitigated. Further objects of the invention relate to the provision of specific direct digital frequency synthesis and phase locked loop synthesis circuit arrangements.

According to a first aspect of the present invention a method of reducing the effects of distortion in an analogue signal derived by repetitively accumulating digital numbers as a function of time and subjecting the results of accumulation, representing phase of the analogue signal, as phase related numbers to digital-to-analogue conversion, comprises the steps of producing digital random or pseudorandom numbers (as herein defined) in synchronism with the accumulation of phase related numbers, modifying values of phase related numbers in accordance with the values of the random numbers, applying the randomly modified phase related numbers and the random numbers to conversion means so as to derive analogue values directly related thereto and combined in such a manner as to eliminate the effect of the random numbers from the analogue signal derived as a function of time from the analogue values.

The method may be applied to the synthesis of analogue signals having particular frequencies defined by the digital numbers, in particular to so-called direct digital synthesis (DDS), by combining analogue values resulting from conversion, and phase locked loop synthesis (PLLS) by utilising the analogue values resulting from conversion in loop phase correction.

In accordance with a second aspect of the present invention a circuit arrangement for deriving an analogue signal comprises system clock means, a digital frequency number generator responsive to the system clock means to generate in each clock cycle a digital number representative of the frequency of a signal to be generated by the arrangement, a digital accumulator operable repetitively to accumulate to a predetermined total digital frequency numbers generated as phase increments of the signal and to provide each new total as a phase number representing the current signal phase value, means responsive to a phase number to provide a digital function number representative of an amplitude value of the signal to be generated at the current phase value, random or pseudorandom (as herein defined) digital number generating means, arithmetic logic means operable to modify at least some digital function numbers each by a generated random digital number, and conversion and combining means responsive to digital numbers provided by the arithmetic logic means and by the random digital number generating means to derive and combine in the analogue domain signal values directly dependent on said digital number values, substantially eliminating the effect of the random digital numbers to form the analogue signal directly related to the values of the function numbers.

The conversion and combining means may be arranged to combine analogue values derived from the function number and random number to directly synthesise the analogue signal or use the analogue signals separately to affect control, such as phase shift, of signal values combined to provide control elsewhere, for instance, an analogue phase error signal that is used to control a phase locked loop frequency synthesiser.

The conversion and combining may be effected simultaneously, by applying numbers derived from the function number and random number respective to digital-to-analogue conversion means and further digital-to-analogue conversion means, and algebraically combining the analogue values or their effects, or sequentially, by way of multiplexing means, single digital-to-analogue conversion means and filtering means to derive an average of the analogue effects of the sequential conversions.

In accordance with a third aspect of the present invention a direct digital frequency synthesiser comprises system clock means, a digital frequency number generator responsive to the system clock means to generate in each clock cycle a digital number representative of the frequency of a signal to be generated by the arrangement, a digital accumulator operable repetitively to accumulate to a predetermined total digital frequency numbers generated as phase increments of the signal and to provide each new total as a phase number representing the current signal phase value, means responsive to a phase number to provide a digital function number representative of an amplitude value of the signal to be generated at the current phase value, digital-to-analogue conversion means responsive to a digital number applied thereto to provide an analogue signal value relative to an analogue datum, random or pseudorandom digital number generating means, arithmetic logic means operable to modify at least some digital function numbers each by a generated random digital number and apply the randomly modified digital function number to the digital-to-analogue conversion means, further digital-to-analogue conversion means responsive to said generated random digital number to provide an analogue signal value relative to said analogue datum, and combining means operable to combine in the analogue domain the analogue signal values produced by the digital-to-analogue conversion means and further digital-to-analogue conversion means substantially to eliminate the effect of the random digital numbers on the analogue signal values.

In accordance with a fourth aspect of the present invention a phase locked loop frequency synthesiser includes a source of reference frequency, being a fraction of the desired synthesised frequency, a voltage controlled oscillator, loop filter, programmable frequency divider responsive to an applied digital integer to divide the oscillator output frequency by said integer value, phase comparator means operable to compare signals derived from the source of reference frequency and from the programmable frequency divider and apply the result by way of the loop filter to control the oscillation frequency of the voltage controlled oscillator, and a circuit arrangement for deriving an analogue phase control signal including means to derive a digital number representative of the desired oscillation frequency, a digital accumulator operable to accumulate said numbers representative of desired oscillation frequency at a rate corresponding to the reference frequency and indicate the phase of the desired oscillation, the accumulator having a carry output, indicative of a $2\pi$ phase increment in the desired oscillation frequency, connected to the programmable divider to effect a cycle shift in the oscillator frequency applied thereto by temporary change of the division integer, and digital-to-analogue conversion means responsive to the contents of the accumulator, being a phase number representing the phase of the desired oscillation frequency signal, to provide a function of the phase number as an analogue signal value, phase modulation means responsive to said analogue signal value to modulate the phase of one of the reference or divided oscillator frequency signals for input to the phase comparator, said circuit arrangement further including random or pseudorandom number (as herein defined) generating means operable to generate for each cycle of the reference frequency a number, arithmetic logic means, having a capacity equal to a phase number rep-

resenting a $2\pi$ phase shift of the desired oscillator frequency, operable to receive the phase number from the accumulator and said random number and provide a component of a randomly modified phase number less than $2\pi$ to said digital-to-analogue conversion means, and in response to overflow of the arithmetic logic means, a $2\pi$ component of phase shift of the desired oscillator signal to the programmable frequency divider to shift the divisor integer thereof for one cycle of the reference frequency in one sense and in the following cycle in the opposite sense to counter the effect of said $2\pi$ phase shift in the randomly modified phase number, further phase modulation means operable to receive in parallel with the phase modulation means the same reference or divided oscillator frequency, further phase comparator means operable to receive the signal modulated by the further phase modulation means and the other of said reference or divided oscillator frequency signals, further digital-to-analogue conversion means responsive to said random number to provide as a function thereof an analogue signal value to the further phase modulation means to modulate the phase of the reference or divided oscillator frequency signal therein, and analogue signal combining means operable to sum algebraically the outputs of the phase modulation means and further phase modulation means for application to the loop filter means.

In this specification the term "random number" is employed for convenience in referring to any suitable form of number, whether it is derived from a truly random source or by pseudorandom techniques. Techniques for generating such numbers are well known and do not require detailed discussion, the only constraints on "randomness" of such a number being that it does not repeat more frequently than the resolution of any system for which the analogue signals are derived. Similarly, the means for generating such a number is referred to as random (digital) number generating means.

Embodiments of the invention will now be described by way of example with reference to the accompanying drawings, in which:-

Figure 1 is a schematic block diagram of the known basic form of direct digital frequency synthesiser described above,

Figure 2 is a graphical representation of the relationship between the digital numerical values and analogue voltage levels in the generation of a sinusoidal signal function by digital-to-analogue conversion,

Figure 3 is a schematic block diagram of a first basic form of direct digital frequency synthesiser according to the present invention,

Figure 4 is a schematic block diagram of a second basic form of direct digital frequency synthesiser according to the present invention,

Figure 5(a) is a schematic block diagram of a modified form of the direct digital frequency synthesiser of Figure 4 including a first means of applying at random a dither to rounding of the truncated digital word applied to the DAC,

Figure 5(b) is a schematic block diagram of a modified form of the direct digital frequency synthesiser of Figure 4 including a further means of applying at random a dither to rounding of the truncated digital word applied to the DAC,

Figure 6 is a schematic block diagram of the direct digital frequency synthesiser of Figures 3 to 5 including means for introducing a phase dither to the digital phase number,

Figure 7 is a schematic block diagram of a phase locked loop filter associated with the direct digital frequency synthesiser of Figures 3 to 6,

Figure 8(a) is a representation of the output signal amplitude against frequency (up to clock frequency) for the known direct digital frequency synthesiser of Figure 1 showing the prominence of discrete spurii close to the desired frequency,

Figure 8(b) is a representation of the output signal amplitude against frequency for a direct digital frequency synthesiser in accordance with the invention showing the decorrelation of spurii into wideband noise,

Figure 8(c) is a representation of output signal amplitude against frequency for a synthesiser in accordance with the invention showing the effect of the filter of Figure 7 thereon,

Figure 9 is a block diagram of a known form of phase locked loop frequency synthesiser incorporating a circuit arrangement synthesiser for phase interpolating between integral divisor values N,

Figure 10 is a block diagram of a phase locked loop frequency synthesiser according to the present invention,

Figure 11 is a schematic block diagram of a third basic form a direct digital frequency synthesiser according to the present invention including multiplexing means, and

Figure 12 is a schematic block diagram of an alternative form of phase locked loop frequency synthesiser according to the invention including multiplexing means.

For ease of understanding the invention reference is made to Figure 2 which shows at 17 approximately one cycle of an analogue signal, typical of that to be generated by a direct frequency synthesiser, having a sinusoidal waveform. The waveform is shown stepped as indicative of its production by digital-to-analogue conversion in the absence of subsequent filtering.

Such a signal, or rather the individual analogue values which define it, are generated from digital P-bit words defining numbers representing the step values of the signal stored in a function generator so that between peaks of the waveform there are $2^P$-1 quantisation steps as depicted by the left hand ordinate axis. It is convenient when an analogue signal having such a sinusoidal waveform is generated to consider the analogue signal with respect to an analogue datum or 'zero' level 18 midway between the peaks so that analogue values, that is, voltages, comprising the signal are either positive or negative with respect to the analogue datum, as depicted by the right hand ordinate axis, and to employ digital to analogue conversion means which produces such bipolar signals.

It will be seen that in such an arrangement a digital number $2^{P-1}$-1 represents the analogue datum of 0 volts so that any number between $2^{P-1}$ and $2^{P-1}$ inclusive is converted to an analogue signal value of between 0 and +V volts whereas any number between 0 and $2^{P-1}$-1 inclusive is converted to an analogue signal value of between -V and 0 volts.

In using a P-bit binary word for the number the most significant bit represents the number magnitude being greater than $2^{P-1}$-1 or not and forms a convenient means of deciding whether the number represented by the word relates to a positive or a negative analogue signal value.

Referring now to Figure 3 this shows a schematic block diagram of a first basic form 20 of direct digital frequency synthesiser according to the present invention. Those elements which are common to the known form 10 of Figure 1 are given the reference numbers used in that Figure.

The synthesiser 20 is similar to that already described, comprising a system clock 11, frequency number generator 12, accumulator 13 which produces a digital phase number,means, such as a function generator 14 in the form of a ROM look-up table addressed by the phase number, to provide a function number related to the phase number by the waveform of the signal to be generated, usually, but not necessarily, a sinusoidal waveform, digital-to-analogue conversion (DAC) means 15 and optional low pass filter means 16. The filter cut-off is arranged to reject images of the frequency generated at frequencies greater than half the system clock rate.

The DAC means 15 is a P-bit fixed reference device capable of operation at high system clock rates. The function generator 14 conveniently produces a function number as a P-bit word but the phase number applied thereto to address the look-up table may comprise a (P+n)-bit word, the function generator effectively truncating the accuracy or resolution of the phase word to the resolution of the DAC means.

In addition to the above, and in accordance with the invention, the synthesiser 20 comprises conversion and combining means shown generally at 21. This comprises arithmetic logic means 22 in the form of an arithmetic logic unit (ALU) of conventional type which has first and second input ports 23, 24 and in response to an instruction at 25 is able to operate either in an addition mode, in which the number presented at second port 24 is added to the number presented at first port 23, or in a subtraction mode, in which the number presented at the second port 24 is subtracted from the number presented at the first port. The instruction at 25 is conveniently a 1-bit binary word to switch the ALU between arithmetic modes and the ALU is disposed between the function generator 14 and DAC means 15 to receive at the first port 23 the P-bit function number and deliver to DAC means 15 a P-bit modified function number. The ALU 22 may also have a carry output 22' which flags an overflow condition in addition and a borrow input 22" which accepts an input in case of a negative "overflow" condition in subtraction.

Random number generating means 27 is responsive to the system clock 11 to produce for each clock cycle a random digital number word of (P-1)bits. As indicated above, the random number may in practice comprise a pseudorandom number, it being immaterial how the number is formed provided it meets any constraints on repetition.

The (P-1)-bit random number word is applied to the second port 24 of the ALU 22 and to further DAC means 28, as similar to DAC means 15 as is practicable.

The analogue voltage output 29 of DAC means 15 and analogue voltage output 30 of further DAC means 28 are applied to combining means indicated generally at 31, which is operable to combine in the analogue domain signal values directly dependent on the analogue values provided by DAC means 15 and further DAC means 28. In this DDS the analogue values from the DAC means themselves are combined in an analogue summing device 32 of the combining means, the output of which is applied to the filter 16, if present.

Basically, operation of the conversion and combining means comprises adding the random number to, or subtracting it from, the function number in the ALU 22 to derive a randomly modified function number. The words representing the randomly modified function number and random number are then simultaneously converted to analogue form in the DAC and further DAC means 15 and 28 respectively and the analogue signal values are combined algebraically so as substantially to eliminate the effect of the random digital number on the analogue signal value output. To this end, if the ALU 22 is operated in its addition mode the combining means

7

basically operates to subtractively combine the analogue values whereas if the ALU 22 is operated in its subtraction mode the combining means basically operates to additively combine the analogue values.

The arrangement 20 is operated to prevent overflow of the ALU 22 by utilising as the 1-bit mode setting instruction to 25 the most significant bit (MSB) of the function number word, the arrangement being such that an MSB = 1 puts the ALU into the subtract mode and an MSB=0 puts the ALU into the addition mode.

This 1-bit ALU instruction word is also used by combining control means 33 to control the sense of combining the analogue signal values.

Making reference again to Figure 2 it will be appreciated that the (P-1)-bit random number may only take values of 0 to $2^{P-1}-1$ and that the analogue datum corresponds to a digital value of $2^{P-1}-1$. The DAC means 28 is a P-bit device, like DAC means 15, and in order to convert a random number between 0 and $2^{P-1}-1$ into a positive analogue value between 0 and +V (corresponding to a digital number between $2^{P-1}$ and $2^P-1$) the MSB input to the DAC means 28 is set to a binary 1.

Thus the combining control means 33 is responsive to a function number word MSB=1 to put the MSB input to further DAC means equal to 1, whereby the ALU 22 subtracts and the summing means 32 additively combines.

In order to effect subtractive combination in the summing means 32, the combining control means could be arranged to alter the operation of the summing means 32 but, preferably, the combining means 31 includes complement means 34 to which the (P-1) bit random number is applied and which functions in response to a function number word MSB=0 to produce the 2's complement of the random number. Thus when the ALU 22 adds, the combining control means is arranged to switch the inputs to the further DAC means 28 so that the MSB=0 and the 2's complement of the random number provides the (P-1) least significant bits. The further DAC means thus derives an analogue signal value negative-going with respect to the analogue datum and by additively combining with the value of the randomly varied function number word in summing means 32 effects subtractive combination.

It will be seen that the 2's complement operation effectively subtracts the (P-1)-bit random number word from a P-bit number word whose MSB is 1 and the remaining bits 0, the result applied to the further DAC means 28, being the least significant (P-1) bits of the P-bit number word. For a random number greater than 0 the MSB of this P-bit number word is 0 and the (P-1) least significant bits are a true representation of the 2's complement of the random number. However, when a random number equal to 0 is generated the (P-1) least significant bits resulting from the operation will also all be zeroes and to prevent a misleading analogue voltage being generated in such circumstances the complement means 34 may be arranged to have a subsidiary output 34', or a P-bit word output, to the further DAC means 28. Such a subsidiary output 34' may force the MSB input to the further DAC means to 1, in a manner similar to combining control means 33, when the complement means detects a random number = 0. Alternatively, the complement means may at all times provide a P-bit word output to the further DAC means, the MSB of which is 0 for a non-zero random number and 1 only for a random number = 0.

The arrangement 20 thus displaces any function number value greater than $2^{P-1}-1$ by subtraction of a random number of magnitude less than $2^{P-1}$ or displaces any function number value less than $2^{P-1}$ by addition of a random number of magnitude less than $2^{P-1}-1$.

It will be seen that the randomly modified function number applied to DAC means 15 is capable of wide variations in value and over a period of time utilises conversion at all DAC stages and whereas the function number itself may fall into a repetitive pattern it does not result in repetitive use of relatively few DAC stages. This may be contrasted with switching the function number between two DACs wherein effective displacement of the function number on a random basis is confined to within the device-to-device differences exhibited at a particular DAC step at which they have a nominally identical performance. furthermore, the use of similar DAC devices for both paths taken by the function word does not eliminate the effects of linearity of the DAC device type encountered at any particular part of its conversion range.

It will be appreciated that the modified function number applied to the DAC means 15 is randomly different from the function number by up to half its value and the numbers applied to both DAC means 15 and 28 are randomly decorrelated from each other and any conversion errors inherent in the desirably identical DAC means are not reinforced by the summing means 32.

Although in the arrangement 20 the DAC errors are effectively decorrelated for function numbers between 0 and $2^{P-1}-1$ in avoiding overflows in the ALU the "randomisation" of the function number is constrained to subtraction from a certain range of function numbers and addition to a different range of function numbers.

Thus the analogue values representing the random numbers are all positive when the function number is $2^{P-1}$ or greater whereas they are all negative when the function number is $2^{P-1}-1$ or less, that is, the DAC means 28 operates over half of its range for each set of function number values. For any particular example of DAC means the polarity-defined half-ranges may not be perfectly complementary so that when an analogue function is generated, the random analogue values generated as the function crosses the datum level are also subject to a periodic abrupt datum crossing of polarity and any distortion associated with different DAC-half operation may correlate over a period of time.

To improve decorrelation, and make more efficient use of the DAC means, a second basic form of direct digital frequency synthesiser 40 may be constructed as shown in Figure 4. Again, those parts common to the device 20 described above are given the same reference numbers as in Figure 3.

In this arrangement 40, the ALU is instructed as to its operation in addition or subtraction mode by a 1-bit random number instead of the MSB of the function number word. This number, renewed at each system clock cycle, is generated under control of system clock 11 by a random or pseudorandom number generator, conveniently the generator of the (P-1)-bit random number word. Whereas one bit might be tapped from that word for use as the ALU instruction the generator, shown at 27' in Figure 4, conveniently generates a P-bit random number word, the MSB comprising the ALU mode instruction and the (P-1) least significant bits comprising the aforementioned (P-1)-bit random number.

It will be seen that the value of the random number, and whether it is added to, or subtracted from, the function number, is not dependent on the value of the function number and addition or subtraction may result in an overflow of the ALU, including a negative overflow, or borrow requirement at 22".

Considering again the waveform of Figure 2 it will be appreciated that if a random number represented by a (P-1)-bit word is added to any function number having a value between $2^{P-1}$ and $2^P-1$ the total may exceed the ALU limit of $2^P-1$, the remainder being an apparent modified function number of value between 0 and $2^{P-1}-1$. furthermore it will be seen that such an apparent number is not suitable for conversion because of its displacement from the $2^{P-1}-1 = 0$ volts datum. Accordingly, when such an overflow greater than $2^{P-1}$ occurs the remainder is offset by $2^{P-1}$ in order to bring it relative to the datum for conversion in DAC means 15. To compensate for this offset an analogue voltage equivalent to a number $2^{P-1}$, that is, V, has to be subtractively combined at the summing means. A corresponding but complementary procedure is followed for a negative overflow.

The conversion and combining means 21 of Figure 3 may be readily modified to effect the change in procedure, in particular combining control means 33 is modified as shown at 33'.

The combining control means 33' comprises two parts both responsive to the bit value of the mode instruction to the ALU, as supplied now by the random number generator 27', and to overflow, and the sense of it, of the ALU, flagged at carry output 22' or borrow input 22".

A first part 35 of the control means in the absence of an overflow state input from the ALU 22 corresponds to the means 33 described above in responding to an instruction putting the ALU into the subtract mode by providing the further DAC means 28 with an MSB = 1 and the random number word and responding to an instruction putting the ALU into the addition mode by providing the further DAC means with an MSB = 0 and the 2's complement of the random number word.

In response to a negative overflow, a borrow, when the ALU is in the subtract mode a second part 38 of the combining control means forces the MSB of the input to DAC means 15 to 0, effectively offsetting the random number added to the ALU by $2^{P-1}$. In response to a positive overflow when the ALU is in the addition mode the second part 38 forces the MSB of the input to DAC means 15 to 1, again effectively offsetting the random number subtracted at the ALU by $2^{P-1}$.

In response to such a negative overflow the first part 35 of the combining control means forces the MSB input to further DAC means 28 from 1 to 0 to effect a corresponding $2^{P-1}$ shift in the effective value of the random number and offset applied to the ALU. In response to a positive overflow the first part 35 forces the MSB input to further DAC means from 0 to 1 to effect a $2^{P-1}$ shift in the effective value of the random number and offset applied to the ALU.

It will be appreciated that the second part 38 only functions in the event of an ALU overflow. The effect will thus be seen that in the event of an ALU overflow, the remainder, or residue, of the randomly modified function number is offset by $2^{P-1}$ and the effective analogue value of the random signal is offset in an opposite analogue sense to provide a correspondingly offset analogue value by displacing the input to the further DAC means 28.

The connections and states in the circuit may be summarised by the following table:

| ALU mode | Overflow condition | DAC 15 MSB | DAC 28 MSB | Random No. complement |
|---|---|---|---|---|
| Add | No | * | † | Yes |
| Add | Yes | 1 | 1 | Yes |
| Subtract | No | * | 1 | No |
| Subtract | Yes | 0 | 0 | No |

† is normally 0, except for a zero random number when the MSB = 1 as described hereinbefore.

* may be 0 or 1, as dictated by the ALU output, for non-overflowconditions. The non-overflow conditions also summarise operations of the arrangement 20, where the modes are constrained by the MSB of the function word.

The above described arrangements enable an effective decorrelation of the major source of spurious output and, by the use of fixed reference DAC means, operation at high and rapidly changed frequencies.

However such high speed DAC means tend to be limited in resolution to the extent that, as indicated hereinbefore, the function word is truncated in bit resolution with respect to the phase word used to address the function generator. A range of phase numbers, each theoretically able in accordance with the function to define a theoretical function number of the same resolution ((P+n)-bits) as the phase number, actually define each function number truncated in resolution (P-bits) relative to the associated phase numbers and rounded from the constituent theoretical values. The function generator may have the function numbers representing a rounding down or, more conveniently, a rounding up of the constituent theoretical values.

It will be appreciated that such truncation, by not discriminating between theoretical "untruncated" function number values between DAC voltage steps, but forcing them to the precise step values, presents a source of error which, although small in itself for each randomly modified function number, is likely to correlate for all the numbers associated with any step and produce its own set of fourier components.

The truncation error may be reduced by truncation dithering means operable effectively to offset at random the least significant digit of each (truncated) digital function number, that is, the least significant bit (LSB) of the function number word.

Referring to Figure 5(a) this shows a portion of a direct digital frequency synthesiser arrangement 50. The arrangement may be based on either the synthesiser 20 shown in Figure 3 or the synthesiser 40 of Figure 4, the only parts relevant here being the system clock 11, accumulator 13, function generator 14, DAC means 15 ALU means 22 and random number generating means 27/27'. The remainder of the circuit, which may be as either of the above, is not shown.

A first form of truncation dithering means, shown generally at 51 comprises truncation arithmetic logic means 52 comprising an ALU similar to 22 which may, by an instruction to 53, have its arithmetic mode set to an addition mode or subtraction mode. How this mode is set is dependent upon the organisation of the function generator 14. If the function numbers produced thereby have been rounded up then the truncation ALU 53 is set to the subtraction mode. However, if the function numbers have been rounded down then the truncation ALU is set to the addition mode. A first ALU input 54 is arranged to receive a P-bit word, being a P-bit function number from generator 14, or to receive part of a longer (P+i)-bit word produced by generator 14 and truncated in resolution, effectively rounded down, by the P-bit input of the ALU. A second ALU input 55 is arranged to receive a 1-bit word comprising a subsidiary function number at a level equal to the LSB of the function number word. The subsidiary function number is provided by random generating means 56 under the control of the system clock 11 to produce a new number each clock cycle. The random number generating means 56 may comprise, or be incorporated in, the random number generator 27/27' used in respect of decorrelation described above but preferably providing a number different from any produced in that operation.

Assuming the truncation ALU is in the subtraction mode, for each function number input to it, the 1-bit random number is subtracted from the function number; this is, the function number word is decremented by 1 at random, depending upon the content of the subsidiary function number word. If the ALU is in the addition mode the function number word is correspondingly incremented by 1 at random.

It will be appreciated that as the truncation dithering means has the effect of altering the LSB of the function number word at the resolution at which the randomly modified function number word is applied to DAC means 15, the truncation dithering means 51 may be disposed between the output of ALU 22 and DAC means 15.

A further form of truncation dithering means may be provided as shown at 50' in Figure 5(b). This figure likewise shows a portion of the synthesiser arrangement 40 but including truncation dithering means 57. This form of truncation dithering means requires that the function numbers provided by the function generator 14 be rounded up in value so that dithering is restricted to an effective random decrementing of the LSB value of the function number word. In accordance therewith there is provided means 58, including a generator 59 operable to provide a one bit random number word, which is operable when the ALU means 22 is in the subtraction mode to activate at random the borrow input 22" to the ALU means to decrement the randomly modified function number by 1. The complement means 34 is made to produce at random a 1's complement of the random number, that is, effectively the 2's complement minus 1, so that when the ALU 22 is in the addition mode an analogue voltage level provided by further DAC means 28 is more negative by the equivalent of a function number word LSB = 1 subtracted from the randomly modified function number.

It will be appreciated that having produced truncation dither as above which 'blurs' the individual DAC step amplitudes there is still a sharp amplitude transition between each of the steps represented by the truncated function numbers due to their relationships with the phase numbers.

Also in accordance with the invention a direct digital frequency synthesiser 60, based on any of the above described synthesisers 20, 40, 50, or 50', and shown in Figure 6 may include digital phase dithering means 61 operable to introduce a limited random dither into the phase number provided by accumulator 13. The phase dithering means 61 comprises dither random number generating means 62 under the control of the system clock 11 to generate a random number, conveniently called a phase dither number, for each clock cycle. This means 62 may comprise, or be associated with, any of the aforementioned random number generation 27, 27', 56 or 59 as appropriate but with a greater number of bits in each number word, and thus finer resolution, than the P-bit words representative of the function number.

The phase dithering means 61 also includes phase dithering arithmetic logic means 63 comprising an ALU having a first input 64 to receive binary digital words representing the phase numbers produced by the accumulator and a second input 65 to receive the binary digital words representing the phase dither numbers. The arithmetic mode of the ALU, that is, whether the phase dither number is added to, or subtracted from, the phase number is not critical and may conveniently be arranged permanently in an addition mode.

The lowest significant bits of the generated phase dither number word are added to the correspondingly lowest significant bits of the phase number word from the accumulator such that the value of the phase number word is randomly increased by up to an amount limited by the number of bits in the phase dither number word. Because of the nature of the function generator, whereby the $2^{P+n}$ phase numbers from the accumulator address $2^P$ function numbers successively, it will be seen that $2^n$ consecutive phase numbers are associated with each function number. To effectively dither the phase number to the extent of changing function number level the accumulator numbers are preferably dithered by a minimum value of $2^n$, that is, by a phase dither number word having in excess of n bits and corresponding, by ALU connection, to the least significant n-bits of the phase word. The minimum value of the phase number may be assured by the internal construction of the number generating means 62 or by an external means 66, such as a store of suitable ones of random numbers generated at a rate in excess of system clock rate and having values within a pre-determined range, possibly variable by input 67, the numbers being released and used at system clock rate with successive phase numbers.

Phase dithering per se of the digital phase word word output from such an accumulator has been used in the type of direct digital frequency synthesiser described in the aforementioned US patent no. 4410954 that rejects the use of function generator and DAC means.

Hitherto in direct digital frequency synthesisers the level of spurii believed inherent in using DAC means have overwhelmed any gains to be made by investigation of, and taking practical steps to mitigate the effects of, minor sources of DAC error. In particular, the further and smaller reductions to be made to DAC-induced errors by such above described techniques of truncation dithering and phase dithering of digital words destined for digital-to-analogue conversion represents a new departure for direct digital frequency synthesisers incorporating DAC means.

It will be appreciated by those skilled in that art that the arrangements and techniques described above for reducing the level of spurii close to the desired frequency do not effect cancelling of the spurious emission energy but effect a reduction in the noise correlated at specific frequencies by spreading it widely over the bandwidth of the arrangement defined by the system clock. The overall noise energy of the analogue signal is unchanged but wide spectrum spread of the noise does permit more efficient filtering.

Figure 7 shows a direct digital frequency synthesiser according to any one of the above described embodiments 20, 40, 50, 50' or 60 providing its analogue output signal by way of a phase locked loop filter (PLLF) means 70. The filter comprises voltage controlled oscillator (VCO) 71, phase comparator 72 arranged to receive the synthesised analogue signal and the filter VCO signal and provide the difference signal by way of loop filter 73 to control the frequency of VCO 71. The output of filter VCO 71 also provides the eventual direct digital synthesiser analogue output signal at 74. The PLLF has its pass band centred on the desired frequency to be generated, or within a band of such frequencies if more than one, and employs a low noise VCO such that the wide band noise outside of the PLLF pass band, and due solely to the uncontrolled filter VCO, is at a lower level than the far-from-frequency noise of the signal input to the filter.

Referring to Figure 8(a) this illustrates the relationship between output signal amplitude and frequency (up to system clock frequency) for the known synthesiser of Figure 1. This shows how in addition to the main output 81 at the desired frequency the prominence of discrete spurii 82, 83 etc. close to the desired frequency and due largely to the DAC means, in addition to a lower level of noise 84.

Figure 8(b) illustrates the relationship between output signal amplitude and frequency for the direct digital frequency synthesisers 20, 40, 50, 50' or 60 according to the present invention but without the filter 70. It will be seen how the hitherto prominent close-to-frequency spurii has been replaced by wide band uncorrelated noise 85, albeit of a higher level.

Figure 8(c) illustrates the relationship between output signal amplitude and frequency for the PLLF 70. The pass band of the filter 70 is demarked by the broken lines and it will be seen that within the pass band, and containing the desired frequency, the signal and close-to-frequency noise are passed unattenuated. However outside of the pass band, the uncontrolled filter VCO output aloneprevails and the noise level thereof may readily be made less than of the generated signal and the overall noise energy in the signal output at 74 reduced, giving an overall increase in synthesiser signal-to-noise ratio at the output.

The passive filter means 16 may be retained between the analogue combining means and the PLLF 70.

The bandwidth of the PLLF and any other filter may be chosen having regard to any modulation intended to be impressed upon the nominal desired frequency.

It will be appreciated that in addition to utilising all or various combinations of structures for decorrelation, truncation dither, phase dither and PLL filtering within a single synthesiser the components for effecting the above described operations and minor modifications associated with such changes, may be made without departing from the invention.

For instance, the synthesiser arrangements 20, 40, 50, 50' and 60 may still provide a practicable degree of decorrelation by not effecting addition or subtraction of a random number to every function number, provided that a sufficient number are so modified as to prevent repeated uses of the same steps of DAC means 15. This is of course equivalent to addition or subtraction of a random number = 0, although it may be arranged to occur more frequently than the generation of a truely random number 0.

The ALU 63 of synthesizer 60 is, as said, conveniently retained in one mode, be it addition as described, or subtraction, the effect being a continuous shift of phase due to the continued adding (or subtracting) of the phase dither random number. The shift in phase in the finally generated analogue signal may be readily countered if necessary or avoided by switching the mode of ALU 63 to subtract or add random dither numbers at random to balance out phase shifts.

The DAC means 15 and further DAC means 28 are described as accepting a digital P-bit word representing a number value 0 to $2^P-1$ to derive voltages up to $\pm$ V relative to an analogue datum corresponding to digital number $2^{P-1}-1$.

It will be appreciated that the analogue datum may be set to correspond to any other number represented by a digital word and the offsets etc. applied to the DAC means and further DAC means both in conditions of overflow and non-overflow of the ALU will require adjusting in accordance therewith.

Similarly, within the combining means, the summing means 32 is conveniently arranged to additively combine analogue values provided by the DAC means and further DAC means but as indicated hereinbefore, where the further DAC means is employed to produce an analogue value for subtraction, instead of offsetting its inputs to provide "negative" analogue values for addition, the summing means may be switchable to subtract a straightforward conversion.

The above arrangements have been found to produce satisfactory results at GHz clock rates from 8-bit DAC means and a function generator producing 8-bit function number words truncated from 16-bit or 12-bit address words produced by the accumulator, the simple additional ALU operations being performable at high rate by pipelined processing architectures.

The analogue signal produced and defined by the function generator may of course be of a waveform other than sinusoidal.

Whereas it is usual to generate phase words at higher resolution than most DAC means accept and the function generator provides a convenient site for truncating the resolution, it will be appreciated as indicated above, that such truncation may occur by 'default' at the input of the DAC means or arithmetic logic means.

The phase word itself provides a linearly increasing function number that defines by repetition function having a sawtooth waveform, and when a linear function is used, a function generator may exist solely for the purpose of providing word length truncation or, if a phase number is generated at a resolution to match the DAC means or is truncated by these devices, a specific function generator device may be omitted, the means responsive to a phase number to provide a digital function number being a simple bus connection between the accumulator decorrelation or truncation dithering arithmetic logic means.

Also, the function signal may be provided by a look-up table other than in ROM if speed of access is important or by means other than a look-up table per se, such as a combinational logic unit.

The combining means has been shown and described as combining the analogue signal levels of the DAC means and further DAC means to give a succession of analogue values which as a function of time provide an analogue signal varying according to the function in the generator and at a frequency determined by the frequency number K; that is, the current arrangements 20, 40, 50, 50' and 60 comprise direct digital frequency synthesiser arrangements.

In accordance with the invention, the output of the DAC means and further DAC means of the circuit arrangement may, instead of such direct combination, each be employed to control the functioning of devices, such as modulators, that produce signals having characteristics directly dependent upon the analogue DAC means and further DAC means values for combination in the analogue domain.

A circuit arrangement which generates an anlogue signal having a waveform which is a sawtoothed linearly increasing ramp may be used to provide phase jitter reduction in a phase locked loop type of frequency synthesiser (PLLS). In such a type of synthesiser, a circuit arrangement for generating such a sawtooth analogue signal and in accordance with either of the two preceding paragraphs, may be employed. A circuit arrangement according to the invention comprising the direct digital frequency synthesiser 20, 40, 50, 50' or 60, as described hereinbefore and generating such a linear function, may be employed, in accordance with known practices, to interpolate phase jitter steps introduced therein by combining the analogue signal values output by the DAC means and further DAC means before injecting the composite analogue signal into the phase locked loop. A different form of phase locked loop type of frequency synthesiser including a circuit arrangement according to the invention in which the individual DAC means and further DAC means signals separately modulate the phase of a reference frequency or divided output frequency prior to phase comparison of the individual signals, the results of such comparisons being combined, will now be described with reference to Figures 9 and 10.

Referring to Figure 9, the known form of phase locked loop frequency synthesiser outlined above will be described briefly as a reference point. The synthesiser 90 includes a phase locked loop 91 which comprises a source 92 of a reference frequency, being a fraction of the desired synthesised frequency, a voltage controlled oscillator (VCO) 93, arranged to produce oscillations at the desired frequency at output 94, loop filter 95, programmable frequency divider 96 responsive to an applied digital integer N at 97 to divide the oscillator output frequency by the integer value, and phase comparator means 98 operable to compare signals derived from the reference frequency source 92 with those derived from the divider 96 and apply the result by way of line 99 and loop filter 95 to control the VCO 93.

The synthesiser 90 also includes a signal generating circuit arrangement 100, in effect a direct digital frequency synthesiser of a sawtooth waveform function, which is employed to provide phase interpolation equivalent to programming divider 96 in accordance with a fraction of the integer N.

The signal generating circuit arrangement 100 comprises means 101 for forming a digital number corresponding to the desired oscillator frequency, an accumulator 102 for accumulating said frequency number values at reference frequency intervals. The output of the accumulator, which increases linearly with time as each frequency number is added, is a number representing the phase of the desired oscillator frequency and this is applied to digital-to-analogue conversion (DAC) means 103. The output of the DAC means 103, being an analogue signal, is applied to a controlling input of phase modulation means 104 disposed between the divider 96 and phase comparator 98 and operable to modulate the phase of the divided oscillator signal in accordance with the value of the DAC signal, that is, the phase value number presented by the accumulator.

The accumulator 102 has phase number capacity corresponding to $2\pi$, or one cycle, of the desired oscillator frequency and a carry output 105 which provides a signal when the accumulator reaches its capacity and overflows, which action provides a second input 106 to the programmable divider 96 whereby the divisor is increased from N to (N + 1) for one cycle of the reference frequency to 'lose' one cycle of the oscillator frequency. The accumulator retains the residue of the overflow which provides a base for further numbers to be added.

The periodic changing of divisor from N to (N + 1) introduces a correspondingly sudden phase jitter in the signal provided by the comparator which limits the operating parameters of the phase locked loop and although the analogue phase modulation provided by the DAC derived analogue signal goes some way towards smoothing this effect, the presence of the DAC means itself in the direct digital synthesiser introduces non-linearities which may limit the usable bandwidth of the phase locked loop or the use of desirably high reference frequencies.

Referring now to Figure 10, in accordance with the present invention a phase locked loop frequency synthesiser is shown at 110. Those parts corresponding to the above described synthesiser 90 are shown in broken lines and given the same reference numbers as in Figure 9. The arrangement shown in broken lines from Figure 9 differs only in that the phase modulator 104 is shown as modulating the reference frequency from source 92 rather than the divided oscillator frequency from divider 96. Which signal is modulated is a matter of choice in both arrangements.

Further to the above, and in accordance with the present invention a circuit arrangement 111 which replaces the direct digital synthesiser 100 includes random or pseudorandom number generating means 112 operable to generate for each cycle of the reference frequency a random or pseudorandom number, arithmetic logic means 113, in the form of an arithmetic logic unit (ALU) which is disposed between the accumulator 102 and DAC means 103 to receive at 114 the phase number from the accumulator and at 115 said random number from the generator 112 and provide a randomly modified phase number to the DAC means. The ALU may be arranged to perform additions or subtraction of the numbers, or to switch between the two at random, but conveniently is fixed to perform addition of the numbers. The ALU also has a carry output 116 which provides a signal if the added numbers exceed the capacity of the accumulator. The carry output is thus a flag representative of the true sum of numbers exceeding that remainder actually applied to the DAC means by a phase number equivalent of $2\pi$ of the oscillator frequency. In order to effect such a $2\pi$ phase shift on one of the signals being applied to the phase comparator which is a temporary phase shift associated with the random number used in that reference frequency cycle rather than requiring a change in oscillator frequency, the programmable divider may nevertheless be employed.

The frequency divider, in which a cycle step of division ratio from N to (N + 1) results in a frequency step of the voltage controlled oscillator, may be made to effect a temporary, rather than permanent, frequency shift equivalent to a phase offset of $2\pi$, if the carry output of the ALU is differentiated with respect to time.

The carry output is fed by line 117 to a programming input 118 of the divider 16 whereby it shifts the division ratio by increasing it to (N + 1). The line 117 also addresses a delay circuit 119 which introduces a delay equal to one cycle of the reference frequency and gives an output on line 120 to a programming input 121 of the divider 96 whereby it shifts the division ratio back by decreasing it from (N + 1) to (N - 1) for one cycle of reference frequency before returning it to N.

The synthesiser 110 also includes further phase comparator means 122 which is operable to receive the divided oscillator frequency signal from 96 in parallel with the phase comparator means 98.

The circuit arrangement 111 includes further phase modulation means 123 operable to receive in parallel with phase modulation means 104 the reference frequency signal from source 92 and provide it to the further phase comparator 122.

Further DAC means 124 receives the random or pseudorandom number provided by generator 112 to ALU 113 and is responsive to the number to provide an analogue signal value to the further phase modulation means 123 to control the degree of phase shift it impresses on the reference frequency.

The outputs of the phase comparator 98 and further phase comparator 122 are fed to analogue signal combining means 125 which operates to effect subtraction of the analogue phase error signal provided by further phase comparator 122 from the analogue phase error signal produced by phase comparator 98.

Thus it will be seen that whereas any non-linearity in digital-to-analogue conversion is transferred by the modulation into the loop phase control and hitherto repeated use of the same conversion steps would correlate the non-linearity or switching spike effects into spurious frequency components within, and limiting, the phase locked loop, the digital phase number applied to DAC means 103 is now randomly modified so that conversion is not limited to repeated use of a few of the DAC steps but can be expected to make use of all levels of conversion independently of the phase number and any errors which do occur are not correlated and have no greater effect than wide band noise.

The further DAC means 124 in also processing a random number provides phase modulations by way of the further phase modulator 123 from which correlated DAC error effects are absent so that a combination of the signals in such way as to remove the effects of the random number on the phase number provides effective mitigation of DAC-induced errors. Furthermore, although, as described above, it is clearly possible to combine the analogue signals directly after production by the DAC means 103 and further DAC means 124, in order to remove the effect of the random number on the signal output from DAC means 103 before it is applied in the conventional way to a single phase modulator 104, any non-linearity in the phase modulation by the analogue signal is mitigated by randomly changing the degree of modulation through use of the output of DAC means 103 to the randomly modified phase number. As a furtherance of this the phase comparator 98 is also subjected to a wide and unpredictable range of phase shift of the reference frequency.

Again, application of the converted random number to further modulation means 123 also causes operation over all of its range and, in consequence, the range of the phase comparator so that when the phase comparator outputs are combined at 125, correlation errors due to operation in any particular parts of the phase modulator or phase comparator are effectively randomised.

Although the above represents an improvement on converting the phase number not modified by the random number, the phase number is present only in the analogue signal controlling phase modulator 104 and to make better use of the different phase modulator and phase comparator characteristics means 126, such as multiplexing means, shown by dotted lines, may be included as shown at 126 following the DAC means or at 126' before the DAC means to interchange control of the modulation means 104 by the randomly modified phase number and control of the further modulation means 123 by the random or pseudorandom numbers. Preferably, such interchange is effected at random in synchronism with the reference frequency, that is, possibly for each new random number and phase number produced, and instruction for this may comprise for example the state of a 1-bit random number provided by the random or pseudorandom generator 112 on line 127.

As indicated above, it is immaterial which of the reference or divided oscillator output frequencies is shifted in phase before comparison. Accordingly it will be appreciated that when the analogue signal values of the DAC means are used to shift the phase of the reference frequency the analogue signal values of the further DAC means may be used to shift the phase of the divided oscillator output frequency and vice versa.

It will be seen that the analogue signal values produced by the DAC means and further DAC means may be employed to phase modulate either the reference frequency or the divided oscillator frequency. The further phase comparator 122 and summing means 125 may be omitted and the further phase modulation means 123 disposed between the programmable divider 96 and phase comparator 98, so that both the reference and divided oscillator signals are modulated by the DAC means and further DAC means in such a way that the effects of the random numbers are eliminated in the phase comparator 98.

The circuit arrangement 111 may be employed in other than a phase locked loop frequency synthesiser to provide an analogue signal that it directly dependent on the accumulator output number by comparable modulation of other signal forms suitable for combination in the analogue domain.

Further, as the circuit arrangement configured by the combining means as a direct digital synthesiser may be adapted to perform phase dither and truncation dither so may the arrangement 111 in analogous manner.

In all of the arrangements described hereinbefore the conversion and combining means have involved the use of both digital-to-analogue conversion means for the randomly modified number provided by the arithmetic logic means and further digital-to-analogue conversion means for the random number, or numbers derived from them, as appropriate. In the case of direct digital synthesis the analogue signal values of the conversion means are simply algebraically combined whereas otherwise these analogue values are used to act simultaneously on parallel circuit configurations before such algebraic combination.

The conversion and combining means may alternatively comprise single digital-to-analogue conversion means, multiplexing means operable to receive and store at least one, and preferably both, digital numbers derived from the arithmetic logic means and random number generating means and apply them sequentially to the digital-to-analogue conversion means and filter means to average the successive analogue values derived as a result of the digital-to-analogue conversion.

Such a circuit arrangement may be used in a direct digital synthesiser, although the need to provide an average of sequentially produced analogue signals to eliminate the effects of the random numbers may detract from its value at some frequencies. However, all the analogue values provided by the DAC means are derived from digital numbers having random components and avoid the problems caused by repetitive use of DAC means steps.

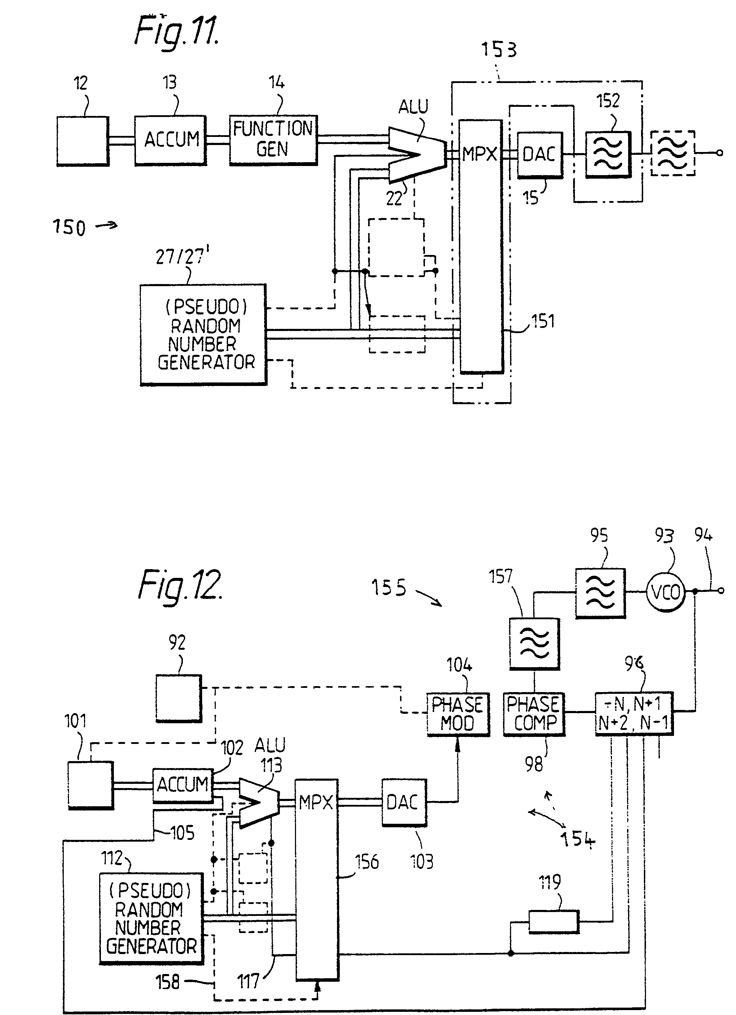

Referring to Figure 11 this shows at 150 a direct digital synthesiser according to this alternative configuration. Components common to figures already described are given the same reference numerals as used therein. Multiplexing means 151 is disposed between ALU 22 and DAC means 15 to receive the output of the ALU and the random number from generating means 27 provide each in turn to the DAC means 15. A filter 152, conveniently designated a multiplex filter to distinguish it from others, disposed at the output of DAC means 23 is arranged to filter the successive analogue signal values which are displaced in time to determine from their average values the effective values of the analogue signal being synthesised.

The multiplexing means 151 and multiplexing filter 152, by dividing the use of DAC means 15 between numbers related to the randomly generated numbers and the function numbers modified thereby alternately, effectively comprise the combining means 53 by which analogue values of the signal are formed by analogue conversion values of the two digital numbers. Clearly the combining means may be adapted in accordance with the techniques described in relation to Figures 3 to 6 to incorporate phase number dither function word truncation dither and offsetting the digital inputs to each of the DAC means and further DAC means to derive analogue values so displaced with respect to a desired analogue datum as to permit combination by simple summing, the filter 152 now effecting such summing by averaging the successive values.

A circuit arrangement according to the present invention and using such multiplexing means and single DAC means may also be used in the control of a phase locked loop synthesiser of the type shown in Figure 9. Such an arrangement is shown at 154 in Figure 12 which illustrates, as a whole, a phase locked loop synthesiser 155 similar to the arrangement 110 of Figure 10, except for replacement of the further DAC means 124, further phase modulation means 123, further phase comparator 122 and analogue summing means 125 by multiplexing means 156 and multiplexing filter means 157. The multiplexing means 156 receives the residue number output of the ALU 113 and the random number from generator 112 and alternately addresses them to the single DAC means 103. When the multiplexing means is directing the ALU output to the DAC means to modulate the phase of either reference (as shown) or divided oscillator signal, any overflow from the ALU is also operable on programmable divider 96 as described above. Sequential phase error signals from comparator 98 arising from the phase shifts brought about by the modified phase number and by the random number to correct the modification are averaged in the multiplexing filter 157.

It may be more convenient if the ALU 113 is operated in a subtract mode in order to enable the multiplexing filter 157 to supply sum effects of the successive conversions to eliminate the effects of the random number. The order in which the two numbers are applied to the DAC means 98 may be interchanged at random by means of a connection 158 between the random number generating means 112 and multiplexing means 156 in a manner corresponding to the connection 127 of Figure 10.

It will be understood that any manipulations to the individual digital numbers applied to DAC means or further DAC means of arrangement 110 of Figure 12 may likewise be performed on the numbers applied to the multiplexing means.

## Claims

1. A circuit arrangement (20,40,50,50',60,70,111,150,155) for deriving an analogue signal comprising system clock means (11,92), a digital frequency number generator (12,101) responsive to the system clock means to generate in each clock cycle a digital number representative of the frequency of a signal to be generated by the arrangement, a digital accumulator (13) operable repetitively to accumulate to a predetermined total digital frequency numbers generated as phase increments of the signal and to provide each new total as a phase number representing the current signal phase value, means (14,102) responsive to a phase number to provide a digital function number representative of an amplitude value of the signal to be generated at the current phase value, and characterised by random or pseudorandom (as herein defined) digital number generating means (27,27',56,112), arithmetic logic means (22,113) operable to modify at least some digital function numbers each by a generated random digital number, and conversion and combining means (15,28,31; 15,153; 103,98,104,124,122,123,125; 103,104,98,156,157) responsive to digital numbers provided by the arithmetic logic means and by the random digital number generating means to derive and combine in the analogue domain signal values directly dependent on said digital number values, substantially eliminating the effect of the random digital numbers to form the analogue signal directly related to the values of the function numbers.

2. An arrangement as claimed in claim 1 in which the conversion and combining means includes digital-to-analogue conversion means (15,102) having an effective digital resolution lower than the accumulator (13,102) whereby a range of phase numbers, each theoretically able in accordance with the function to define a theoretical function number of the same resolution as the phase number, defines each function number truncated in resolution relative to the phase numbers and rounded from the constituent theoretical values, and characterised by truncation dithering means (51,57) operable effectively to offset at random the least significant digit of each truncated digital function number applied to the conversion means (15,103) in accordance with the sense of truncation rounding applied.

3. An arrangement as claimed in claim 2 characterised in that the truncation dithering means comprises truncation arithmetic logic means (52,22) arranged to receive or derive said function number having the same digital resolution as the conversion means at one input (54) and to receive a one bit random subsidiary function number at another input (55,22") and operable to reduce, by subtraction of the random subsidiary function number, the least significant bit of a rounded-up function number or to increase, by addition of the random subsidiary function number, the least significant bit of a rounded-down function number.

4. An arrangement as claimed in any one of claims 1 to 3 characterised by phase dithering means (61) operable to introduce a limited random dither into the phase number.

5. An arrangement as claimed in claim 4 characterised in that the phase dithering means comprises means (62,66) under the control of the system clock to generate, for each clock cycle, a random number having both an effective resolution equal to that of the phase number and a number value in a range not less than the number of consecutive phase numbers associated with each function number and phase dithering arithmetic logic means (63) arranged to receive at a first input (64) the phase numbers and at a second input (65) said random numbers and operable to modify the phase numbers in accordance with the random numbers at the second input and to provide dithered phase numbers.

6. A circuit arrangement as claimed in any one of the preceding claims characterised in that the conversion and combining means comprises digital-to-analogue conversion means (15,103) responsive to the contents of the arithmetic logic means (22,124) to provide an analogue signal value relative to an analogue datum, further digital-to-analogue conversion means (28,124) responsive to the said generated random digital number to provide an analogue signal value relative to said analogue datum and analogue combining means (31; 98,104,122,123,125) operable to receive signal values from both the digital-to-analogue conversion means and the further digital-to-analogue conversion means to derive said analogue signal.

7. An arrangement as claimed in claim 6 characterised in that the analogue datum is defined as the analogue value corresponding to the digital number substantially mid-way between the mawimum and minimum values of the digital function number, the arithmetic logic means (22,113) is responsive to an instruction to operate in an arithmetic logic means addition mode to add the random number to the function number or operate in a subtraction mode to subtract the random number from the function number, and the combining means includes analogue summing means (32), operable to additively combine the signal defined by the analogue values from the digital-to-analogue conversion means and the further digital-to-analogue conversion means, and combining control means (33,33′) responsive to the mode of the arithmetic logic means to modify the random number applied to the further digital-to-analogue conversion means so as to produce therefrom analogue values which in the subtraction mode of the arithmetic logic means (22) and in the absence of overflow thereof are positive with respect to the analogue datum and which in the addition mode of the arithmetic logic means and in the absence of overflow thereof are negative with respect to the analogue datum.

8. An arrangement as claimed in claim 7 characterised in that the random digital number has a value represented by an operative part of a random number word one bit shorter than the digital function number word, the further digital-to-analogue conversion means (28) is arranged to convert a digital binary number word having one bit more significant than the operative part of the random number word, said most significant bit being determinant of whether the analogue signal value produced by the conversion means is positive or negative with respect to the analogue datum, the combining means (31) includes complement means (34) for the random number and the combining control means (33,33′) is responsive to the subtraction mode of the arithmetic logic means to apply said operative part of the random number to the further digital-to-analogue conversion means and set the most significant bit input to the further digital-to-analogue conversion means to provide an analogue signal value positive with respect to the analogue datum and responsive to the addition mode of the arithmetic logic means to apply 2's complement of the operative part of the random number to the further digital-to-analogue conversion means and set the most significant bit input to the further digital-to-analogue conversion means to provide an analogue signal value negative with respect to the analogue datum.

9. An arrangement as claimed in claim 7 or claim 8 characterised in that the instruction for the operating mode of the aritmetic logic means (22) comprises the most significant bit of the function number, a bit value indicative of the function number having a value less than half of the maximum placing the arithmetic logic means in the addition mode.

10. An arrangement as claimed in claim 7 or claim 8 characterised in that the instruction for the operating mode of the arithmetic logic means (22) comprises a randomly generated digital binary word, and the combining control means (33′) includes means responsive to overflow of the arithmetic logic means (22) to displace the value of the randomly varied function number by the difference between the digital datum and the digital number corresponding to the analogue datum and modify the analogue combination in the opposite sense

17

EP 0 452 031 A2

by the analogue value corresponding to said difference.

11. An arrangement as claimed in claim 10 when dependent on claim 8 characterised in that the control means (33') is responsive to overflow from the arithmetic logic means (22) in the addition mode to force the digital-to-analogue conversion means (15) to provide a positive analogue signal value shifted negatively by the analogue magnitude equivalent to the difference between the digital datum and the digital number corresponding to the analogue datum and to set the most significant bit input to the further digital-to-analogue conversion means (28) to provide an analogue signal value shifted positively by the analogue magnitude equivalent to the difference between the digital datum and the digital number corresponding to the analogue datum, and is responsive to overflow from the arithmetic logic means (22) in the subtraction mode to force the digital-to-analogue conversion means (15) to provide a negative analogue signal value shifted positively by the analogue magnitude equivalent to the difference between the digital datum and the digital number corresponding to the analogue datum and to set the most significant bit input to the further digital-to-analogue conversion means (28) to provide an analogue signal value shifted negatively by the analogue magnitude equivalent to the difference between the digital datum and the digital number corresponding to the analogue datum.

12. An arrangement as claimed in any one of the preceding claims characterised in that the combining means (31, 31') is arranged to combine algebraically the analogue signals resulting from conversion of the digital numbers provided by the arithmetic logic means (22) and by the random digital number generating means (27,27',56) to effect direct digital synthesis of an analogue signal and further characterised by filter means (70), including a phase locked loop having a bandwidth containing the synthesised frequency and a voltage controlled oscillator (71) operable outside the bandwidth of the phase locked loop, operable to receive the signal provided by the combining means and produce for the arrangement a noise signal lower in amplitude than the broadband noise of the analogue signal produced at the combining means.

13. An arrangement (111,154) as claimed in any one of claims 1 to 11 characterised in that the combining means includes modulation means (104,123), responsive to each of the analogue values provided by the conversion means (103,124), to modulate the phase of first and/or second signals having a frequency corresponding to the system clock frequency and phase comparison means (98,122), operable to compare the phases of the first and second signals as modified by phase modulation, to provide an analogue signal value representative of phase difference between them and directly dependent upon the analogue values produced by the conversion means.

14. A phase locked loop frequency synthesiser (110,155) including a source of reference frequency (92), being a fraction of the desired frequency, a voltage controlled oscillator (93), loop filter (95), programmable frequency divider responsive to an applied digital divisor number to divide the oscillator output signals by an integer value (96), and characterised by a circuit arrangement (111,154) as claimed in claim 13 in which the means (102) responsive to the phase number accumulated to provide a digital function number is arranged to provide a function number which increases linearly with time in accordance with the accumulated phase number, the system clock frequency corresponds to the reference frequency, the combining means (98,104,122,123, 125,157) is disposed to receive one of said reference frequency signals or divided oscillator output signals as said first signal and to receive the other signal as said second signal and provide an analogue signal to the loop filter to control the oscillation frequency of the voltage controlled oscillator, the means to provide a digital function number, in response to an overflow of accumulated phase number, indicative of $2\pi$ phase of the desired oscillator frequency, is arranged to increment the divisor integer of the programmable frequency divider by one for one cycle of the reference frequency and the arithmetic logic means (113), in response to an overflow indicative of a digital function number corresponding to an accumulated phase number magnitude temporarily exceeding a $2\pi$ phase shift of the desired oscillator frequency, is arranged to effect a correspondingly temporary phase shift in the divided oscillator signal by shifting the devisor integer of the programmable frequency divider by one in one sense for one cycle of the reference frequency and in an opposite sense for the next cycle.

15. A method of reducing the effects of distortion in an analogue signal, derived by repetitively accumulating digital numbers as a function of time and subjecting the results of accumulation, representing phase of the analogue signal, as phase related numbers to digital-to-analogue conversion, characterised by the steps of producing digital random or pseudorandom numbers (as herein defined) in synchronism with the accumulation of phase related numbers, modifying values of phase related numbers in accordance with

18

the values of the random numbers, applying the randomly modified phase related numbers and the random numbers to conversion means (15,28; 103,124) so as to derive analogue values directly related thereto and combined (31,31',152,125,157) in such a manner as to eliminate the effect of the random numbers from the analogue signal derived as a function of time from the analogue values.

# *Fig. 1.* (PRIOR ART)

| FREQ K | ACCUMULATOR PHASE = ΣK (13) | FUNCTION GEN (14) | DAC (15) | ≈ (16) |

CLOCK (11)

# *Fig. 2.*

P-BIT DIGITAL FUNCTION No.

$2^P - 1$

$2^{P-1} - 1$

0

$3\pi/2$    $\pi/2$    $3\pi/2$

$2\pi/0$    $\pi$    $2\pi/0$

17

+V

ANALOGUE VALUE

0V   PHASE ANGLE

ANALOGUE DATUM

-V

## Fig. 3.

## Fig. 4.

# Fig.5(a)

# Fig.5(b)

## Fig. 6.

20/40/50

## Fig. 7.

DIRECT DIGITAL
FREQUENCY
SYNTHESISER

20/40/50/60

VCO

Fig.8(a)
(PRIOR ART)

81
82
83
84

OUTPUT AMPLITUDE

FREQUENCY

Fig.8(b)

85

OUTPUT AMPLITUDE

FREQUENCY

Fig.8(c)

PLL ENVELOPE

OUTPUT AMPLITUDE

FREQUENCY

# Fig.9.

# Fig.10.

*Fig.11.*

*Fig.12.*